# FASCICULE DE BREVET EUROPEEN

(11) **EP 1 579 510 B1**
(45) Date de publication et mention de la délivrance du brevet: **11.04.2012**
(21) Numéro de dépôt: 03796129.9
(22) Date de dépôt: 02.12.2003
(51) Int. Cl.: H01L 31/08, H01L 31/0224, G01T 1/24, H01L 27/146

(54) **DISPOSITIF DE DETECTION PHOTO-ELECTRIQUE ET NOTAMMENT DE RAYONNEMENT X OU GAMMA**
EINRICHTUNG ZUR FOTOELEKTRISCHEN DETEKTION INSBESONDERE FÜR RÖNTGEN- ODER GAMMASTRAHLUNG
DEVICE FOR PHOTOELECTRIC DETECTION AND IN PARTICULAR OF X OR GAMMA RADIATION

(30) Priorité: 19.12.2002 FR 0216149
(43) Date de publication de la demande: 28.09.2005
(73) Titulaire: Commissariat à l'Énergie Atomique et aux Énergies Alternatives, 75015 Paris (FR)
(72) Inventeur: PETROZ, Gérard, F-38330 Montbonnot (FR)
(74) Mandataire: Vuillermoz, Bruno
(86) Numéro de dépôt international: PCT/FR2003/003550
(87) Numéro de publication internationale: WO 2004/066402

(56) Documents cités:
- FR-A- 2 793 954
- US-B1- 6 175 120
- US-B1- 6 340 812
- PATENT ABSTRACTS OF JAPAN vol. 1999, no. 08, 30 juin 1999 (1999-06-30) -& JP 11 087683 A (SEMICONDUCTOR ENERGY LAB CO LTD), 30 mars 1999 (1999-03-30)
- PATENT ABSTRACTS OF JAPAN vol. 006, no. 264 (E-150), 23 décembre 1982 (1982-12-23) -& JP 57 162372 A (TOKYO SHIBAURA DENKI KK), 6 octobre 1982 (1982-10-06)

## Description

L'invention concerne un dispositif de détection photo-électrique, plus particulièrement dédié à la détection des rayonnements X et γ, et mettant en oeuvre des détecteurs à semi-conducteurs, plus précisément des détecteurs monolithiques matriciels.

Plus précisément, elle vise un mode particulier de réalisation des électrodes de détection de tels détecteurs matriciels.

Il existe différents types de détecteurs de rayonnement, parmi lesquels figurent traditionnellement les détecteurs à gaz, les détecteurs à scintillateur, et les détecteurs à semi-conducteur. Ces derniers présentent l'avantage de posséder un numéro atomique élevé, permettant d'absorber un maximum de photons incidents, pour une épaisseur minimale de matériau.

En outre, ils présentent également le double avantage de convertir directement le signal photonique en un signal électrique sans conversion préalable en un signal lumineux, et de présenter une bande interdite relativement large. En d'autres termes, les détecteurs à semi-conducteur permettent donc, avec une épaisseur de matériau faible (quelques millimètres) de réaliser une conversion efficace des rayonnements en signaux électriques.

Les semi-conducteurs plus particulièrement choisis sont du type II-VI, tels que par exemple CdZnTe, CdTe, CdTe :Cl, CdTeSe :Cl, CdZnTe : Cl, CdTd :In, CdZnTe :In.

Ces semi-conducteurs à base de Tellure et de Cadmium peuvent être obtenus notamment par une méthode de croissance BRIDGMAN ou THM par exemple, et présentent comme caractéristique majeure, une très haute résistivité électrique (10⁸ - 10" Ωcm), indispensable à la réalisation d'un dispositif de spectrométrie X ou γ, plus particulièrement dédiée à l'imagerie médicale, industrielle ou scientifique.

Le détecteur proprement dit comporte donc un matériau photosensible, constitué d'un parallélépipède réalisé en un matériau semi-conducteur, traditionnellement découpé dans une tranche de lingot, résultant de la réalisation dudit semi-conducteur, et comporte au moins deux faces parallèles, sur lesquels on réalise les contacts électriques, permettant de polariser et de recueillir les signaux électriques produits par les rayonnements incidents.

Par exemple, l'une des faces reçoit une électrode pleine face de polarisation, et la face opposée, est destinée à recevoir une pluralité d'électrodes dites de détection, réparties selon une forme matricielle, définissant les pixels pour la localisation du lieu d'impact des rayonnements incidents au niveau du détecteur. Un tel détecteur est par exemple décrit dans le document JP 11 087683.

D'autres architectures peuvent être envisagées :en particulier, la face recevant le rayonnement n'est pas nécessairement revêtue d'une électrode.

Le document US-B-6 340 812 décrit un dispositif selon le préambule de la revendication 1.

Afin de pouvoir disposer d'un détecteur le plus efficace possible, les contacts électriques réalisés au niveau des électrodes, notamment de détection, ne doivent pas modifier le comportement du dispositif, et doivent par conséquent présenter une résistance négligeable au flux du courant, en comparaison avec celle du matériau. Ces contacts doivent être du type ohmique, c'est à dire avoir une caractéristique courant-tension quasi-linéaire, et mettre à profit une courbure de bande judicieuse au contact métal-semi-conducteur, avoir un effet tunnel à cet endroit et des recombinaisons dans la zone de charge d'espace.

La difficulté majeure réside donc dans la réalisation de ces contacts de type ohmique, sur des matériaux semi-conducteurs, notamment de type II-VI, car outre le comportement électrique convenable qu'il convient d'obtenir, les électrodes doivent être connectées ensuite par exemple à un circuit de lecture.

Ces difficultés reposent donc sur différents problèmes, tenant compte des matériaux mis en oeuvre, outre des dimensions de plus en plus réduites des électrodes de détection.

S'agissant tout d'abord des électrodes, la réalisation d'un contact ohmique avec un matériau à haute résistivité, du type CdTe (et ses composés), est difficile à élaborer, compte-tenu du travail d'extraction élevé du CdTe (5,02 eV). De fait, seuls le platine et l'or sont susceptibles d'être mis en oeuvre. De tels contacts sont réalisés par évaporation ou pulvérisation, et ne sont ni ohmiques, ni bloquants, mais se situent entre les deux.

Parallèlement, d'autres phénomènes physico-chimiques, tels que les états de surface avant dépôt du métal ou l'oxydation de la surface, fixent la hauteur de la barrière de potentiel indépendamment du travail d'extraction du métal.

De fait, l'obtention d'un contact ohmique est donc possible, si les porteurs peuvent circuler librement par effet tunnel.

Ce mode de transport est favorisé par le dépôt électro-chimique de solutions de type chlorure d'or (AuCl₃) ou chlorure de platine (PtCl₄) sur une surface préalablement décapée chimiquement.

Le métal est réduit chimiquement par le Tellure, et agit comme un fort dopant accepteur à la surface du détecteur (voir Publication Ponpon JP 1985 Solid State Electronics Vol. 28 n° 7-689/1985 ; J. Phys. Applied Physics 16(83) 2333-2340 Janick and Triboulet - CNRS).

Ce dépôt par voie électrochimique (également dénommée sous l'expression en langue anglaise « electroless »), à partir de chlorure d'or ou de platine, prend la place du Cadmium à la surface du détecteur, ledit Cadmium venant enrichir la solution électrochimique.

L'épaisseur maximum déposée du fait de l'effet de polarisation et des contraintes intrinsèques de la couche est, en général, inférieure à 500 Å. En outre, l'adhésion du contact est fonction de la préparation de la surface, de la chimie de l'interface métal/semi-conducteur, de l'épaisseur du dépôt mais également de sa surface.

Or, la tendance dans le domaine de la détection nucléaire par exemple, est d'aller vers la réalisation de détecteurs monolithiques pixelisés, dont la surface de l'électrode unitaire tend, à terme vers 50 µm², alors qu'actuellement elle est de quelques millimètres carré. L'adhésion constitue alors un paramètre critique, en particulier lors des opérations d'assemblage.

Cette adhésion est donc capitale, d'autant plus que les matériaux en présence n'ont pas les mêmes coefficients de dilatation. Les variations de température induisent par conséquent des contraintes.

En outre, le contact ohmique réalisé généralement sur ces matériaux, présente l'inconvénient inhérent à la faible épaisseur de l'électrode, qui, ainsi que déjà dit, est typiquement inférieure à 500 Å.

Par voie de conséquence, la connexion à un circuit de lecture s'avère difficile, et nécessite généralement un épaississement du dépôt constitutif de l'électrode, afin d'atteindre quelques milliers d'Angstrôms au niveau de ladite électrode, pour notamment garantir une connexion de qualité.

Or, le dépôt d'une telle couche d'épaississement, réalisée par dépôt sous vide ou par l'adjonction de micro-gouttes de colle conductrice, pose également problème, puisqu'il n'est pas rare d'observer des débordements d'une telle couche, au-delà de l'électrode proprement dite, susceptible de se traduire par une altération de la précision de la détection finale obtenue.

Une autre difficulté réside dans les zones séparant chacune des électrodes de détection, dénommées ci-après zone interpixel.

En effet, afin d'aboutir à une fonctionnement correct du détecteur, notamment en termes de précision, la résistance électrique entre chaque pixel, c'est à dire entre chaque électrode de détection, doit être maximum, et typiquement comparable à la résistance intrinsèque du matériau détecteur, et typiquement quelques giga ohms, afin d'éviter les interactions entre pixels.

Le maintien d'une résistance aussi élevée ne peut être obtenu qu'en évitant toute contamination entre les pixels, et est traditionnellement réalisé en protégeant la surface correspondante du détecteur, soit par une passivation, soit par une encapsulation d'un matériau inerte et parfaitement étanche.

Cependant, le dépôt de telles couches, en particulier d'encapsulation, est délicat, notamment pour des dimensions aussi réduites, car ces couches sont en général de nature plutôt organique, non gravables.

L'objet de la présente invention est de proposer un détecteur photoélectrique, s'affranchissant de ces différents inconvénients.

Elle concerne donc un dispositif de détection photoélectrique, plus particulièrement destiné à la détection de rayonnements X ou γ, comportant un détecteur matriciel monolithique, constitué d'un matériau semi-conducteur, dont une face comporte une pluralité d'électrodes de détection, selon un principe de pixelisation, chaque électrode correspondant à un pixel, étant destinée à être connectée électriquement, notamment à un circuit de lecture, et étant séparée des électrodes adjacentes par une zone intermédiaire isolante, dite zone inter-pixel, les électrodes de détection et les zones inter-pixels étant situées selon deux niveaux différents, au niveau du détecteur.

Il se caractérise en ce que les électrodes de détection sont positionnées sur la surface du matériau semi-conducteur après réalisation d'une gravure profonde, ménagée au niveau des zones d'implantation desdites électrodes.

En d'autres termes, l'invention consiste à aménager la face de détection du détecteur, de telle sorte que, les électrodes de détection et les zones inter-pixel ne sont pas situées à un même niveau, c'est à dire ne sont pas situées dans le même plan, et notamment que les électrodes de détection sont situées à un niveau inférieur à celui des zones inter-pixel. Il sera démontré dans la suite de la description, différents avantages obtenus de par cette configuration particulière.

Avantageusement, le matériau semi-conducteur est du type II-VI.

En outre, selon une forme particulière de réalisation de l'invention, le détecteur matriciel présente une face orientée en direction du faisceau incident du rayonnement à détecter, revêtue d'une électrode de polarisation, et dont la face opposée comporte une pluralité d'électrodes de détection du type de celles précédemment décrites.

La manière dont l'invention peut être réalisée et les avantages qui en découlent ressortiront mieux des exemples de réalisation qui suivent, donnés à titre indicatif et non limitatif, à l'appui des figures annexées.
La figure 1 est une représentation schématique en perspective du détecteur, conforme à l'invention.
La figure 2 est une représentation schématique en section d'un principe d'assemblage du détecteur avec un circuit de lecture.
La figure 3 est une représentation schématique en section illustrant la réalisation de la face de détection du détecteur, selon l'invention.

La description qui suit est plus particulièrement focalisée sur le détecteur de rayonnement (1) proprement dit.

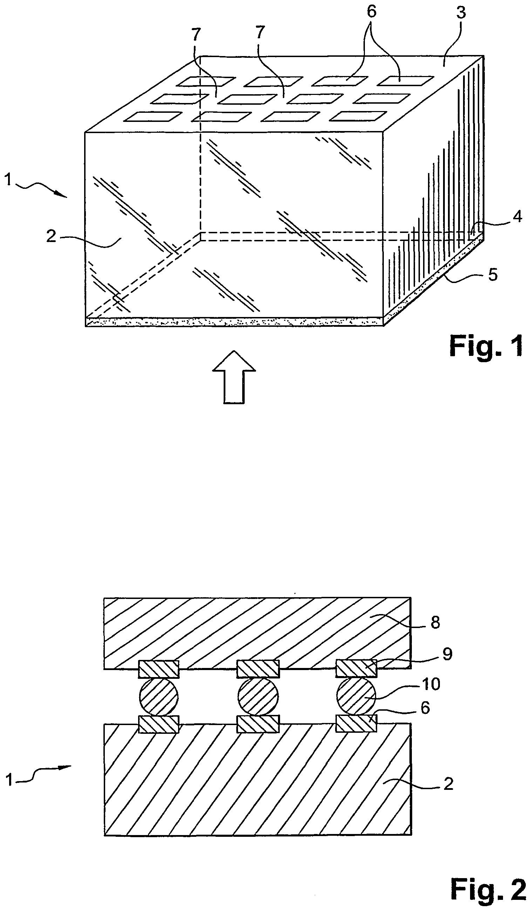

Celui-ci a été schématiquement représenté au sein de la figure 1. Il est fondamentalement constitué d'un matériau actif (2), constitué d'un semi-conducteur, par exemple de type II-VI, de la famille des CdTe.

Il présente deux faces parallèles, respectivement une face de détection (3) et une face (4), cette dernière étant dirigée vers le rayonnement incident, schématisé par la flèche inférieure sur la figure 1.

La face inférieure (4) est revêtue d'une électrode commune de polarisation (5) déposée par voie traditionnelle, par exemple par un dépôt pleine surface d'or selon la technique « electroless ».

La face de détection (3) reçoit quant à elle une pluralité d'électrodes de détection (6), réparties selon une forme matricielle, et séparées les unes des autres par des zones (7) inter-pixel non conductrices.

Cette face de détection (3), et plus particulièrement les électrodes de détection (6) qu'elle intègre, sont destinées à être connectées, ainsi que déjà dit, à un circuit d'exploitation, notamment un circuit de lecture, par exemple selon la technique dite « *FLIP CHIP* », c'est à dire par le biais de micro-billes d'indium (10), tel que représenté sur la figure 2.

Ces micro-billes d'indium connectent les électrodes aux électrodes (9) du circuit de lecture (8). Cette technologie est bien connue de l'homme du métier, de sorte qu'il n'y a pas lieu de la décrire ici en détail.

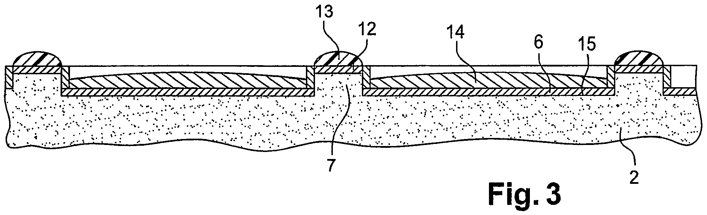

Selon l'invention, telle que représentée en figure 3, la face supérieure (3) du matériau actif (2) subit une gravure profonde (15) au niveau de l'emplacement ultérieur des électrodes de détection (6). Le profil de gravure obtenu dépend de la technique utilisée (humide ou sèche), mais également des conditions utilisées (vitesse de gravure, concentration, agitation).

L'état de surface d'une telle gravure est plus perturbé que celui d'une gravure légère, compte-tenu des précipités des défauts du matériau, permettant de donner des points d'accrochage supplémentaires à l'électrode déposée, et accroît ainsi son adhésion audit matériau actif (2).

Les électrodes de détection (6), typiquement réalisées en or ou en platine, sont alors déposées, par des techniques classiques déjà mentionnées, notamment par voie électrochimique (« Electroless »), à partir de solutions de type chlorure d'or ou chlorure de platine, les zones inter-pixel étant protégées par exemple par une résine photosensible.

Avantageusement, ces électrodes reçoivent une couche supplémentaire d'épaississement dite de recharge (14), réalisée par exemple à base d'argent ou d'or, et limitée strictement à l'électrode. Cette couche de recharge (14) favorise la résistance mécanique de la connexion électrique ultérieure, en s'ancrant en particulier sur les flancs de la gravure profonde.

Corollairement, les zones inter-pixel reçoivent également une couche de passivation (12), par exemple constituée d'un oxyde, obtenu par réaction chimique locale de la surface avec un oxydant. En outre, cette couche de passivation est éventuellement complétée par une couche d'encapsulation (13), par exemple constituée d'une résine acrylique déposée manuellement.

Ainsi qu'on peut bien l'observer sur la figure 3, la couche de recharge (14) déposée sur l'électrode de détection (6) est à la fois suffisante, mais néanmoins telle, que dans cette configuration, l'électrode de détection se situe à un niveau inférieur aux zones inter-pixel (7).

Cette solution technique permet tout d'abord d'aboutir à une meilleure limitation physique de la couche de recharge (14), dans le volume gravé.

Par ailleurs, cette configuration permet d'aboutir à une amélioration importante de l'adhésion de l'électrode finale, selon le profil de gravure des bords, favorable à une résistance mécanique à l'arrachement, notamment lors des électrodes de petites dimensions, typiquement inférieures à 100 µm, qui constituent l'un des buts recherchés dans le domaine technique.

Typiquement, les différences de niveau, quelles que soient les formes de réalisation obtenues, entre les électrodes de détection (6) et les zones inter-pixel (7) peuvent être de quelques micromètres, à quelques dizaines de micromètres.

Cette différence de niveau permet, ainsi que déjà dit, de s'affranchir des risques de contamination réciproque, donc de réduire les risques d'inter-modulation optiques, et partant, de favoriser la qualité de la détection.

Il va être décrit ci-après un mode de réalisation envisageable pour la réalisation de la configuration particulière de détecteurs conforme à la figure 3.

Après conditionnement du matériau actif (semi-conducteur), et découpe et polissage aux cotes souhaitées, on procède tout d'abord et de manière connue à un décapage chimique du matériau, notamment de sa face supérieure destinée à constituer la face de détection (3). On dépose ensuite l'électrode de polarisation, que l'on protège par une résine ou une cire.

On procède alors à une étape de passivation de la face de détection, puis à une photolithographie classique. On procède ensuite à une attaque chimique profonde des zones d'implantation des électrodes, par exemple au Br Méthanol, la zone inter-pixel étant protégée par la passivation et la résine de la photolithographie.

On procède au dépôt des électrodes par voie électrochimique, puis au dépôt du matériau d'épaississement des électrodes, c'est à dire de la couche de recharge (14) sur l'ensemble de la surface.

On procède ensuite à une étape de «lift off », c'est à dire de dissolution de la résine protégeant les zones inter-pixel (7) dans un solvant entraînant le matériau d'épaississement déposé au-dessus.

Enfin, on procède à la dissolution de la protection de la face non pixelisée puis à l'encapsulation des zones inter-pixel par dépôt ou roulage d'un encapsulant.

Enfin, le détecteur obtenu est éventuellement étuvé.

On conçoit aisément tout l'intérêt du détecteur conforme à l'invention.

Tout d'abord, on aboutit à un meilleur confinement tant des matériaux isolants, que des conducteurs, limitant les risques d'inter-modulation optique, et partant favorisant la précision du détecteur.

Les techniques de dépôt mises en oeuvre sont simples et bien maîtrisées.

Enfin, les techniques et les matériaux mis en oeuvre permettent d'améliorer de manière importante la résistance mécanique des électrodes de détection sur le matériau, fiabilisant l'assemblage final en résultant.

## Revendications

1. Dispositif de détection photoélectrique, plus particulièrement destiné à la détection de rayonnements X ou γ, comportant un détecteur matriciel monolithique (1), constitué d'un matériau semi-conducteur (2), dont une face comporte une pluralité d'électrodes de détection (6), selon un principe de pixelisation, chaque électrode (6) correspondant à un pixel, étant destinée à être connectée électriquement, notamment à un circuit de lecture, et étant séparée des électrodes adjacentes par une zone intermédiaire isolante (7), dite zone inter-pixel, les électrodes de détection (6) et les zones inter-pixels (7) étant situées selon deux niveaux différents, au niveau du détecteur, ***caractérisé* :**
• **en ce que** la surface (3) du matériau semi-conducteur (2) recevant les électrodes de détection (6) comporte des gravures profondes (15) ;
• **en ce que** lesdites électrodes de détection (6) sont positionnées au sein de ces gravures profondes (15) ; et
• **en ce que** les électrodes de détection (6) sont situées à un niveau inférieur à celui des zones inter-pixel (7).

2. Dispositif de détection photoélectrique selon la revendication 1, ***caractérisé* en ce que** la face (4) opposée à la surface (3) munie des électrodes de détection (6), et orientée en direction du faisceau incident du rayonnement à détecter est revêtue d'une électrode de polarisation (5).

3. Dispositif de détection photoélectrique selon l'une des revendications 1 et 2, ***caractérisé* en ce que** le matériau semi-conducteur est du type II - VI.

4. Dispositif de détection photoélectrique selon l'une des revendications 1 à 3, ***caractérisé* en ce que** les électrodes de détection (6) sont revêtues d'une couche d'épaississement dite de recharge, également conductrice (14), dont l'épaisseur est telle que les électrodes de détection (6) sont situées à un niveau inférieur aux zones inter-pixels (7).

5. Dispositif de détection photoélectrique selon l'une des revendications 1 à 4, ***caractérisé* en ce que** les différences de niveau entre les électrodes de détection (6) et les zones inter-pixels (7) sont de quelques micromètres à quelques dizaines de micromètres.

6. Dispositif de détection photoélectrique selon l'une des revendications 1 à 5, ***caractérisé* en ce que** les zones inter-pixels (7) reçoivent une couche de passivation (12).

7. Dispositif de détection photoélectrique selon l'une des revendications 1 à 5, ***caractérisé* en ce que** les zones inter-pixels (7) reçoivent une couche d'encapsulation (13).

8. Dispositif de détection photoélectrique selon l'une des revendications 1 à 5, ***caractérisé* en ce que** les zones inter-pixels (7) reçoivent une couche de passivation (12), puis une couche d'encapsulation (13).

## Claims

1. A photoelectric detection device, more particularly intended for detecting X-rays or γ-rays, which comprises a monolithic matrix detector (1) made of a semiconductor material (2), one face of which includes a plurality of detection electrodes (6), according to a pixelization principle, each electrode (6) corresponding to a pixel, being intended to be electrically connected, especially to a read circuit, and being separated from the adjacent electrodes by an insulating intermediate region (7), called an interpixel region, the detection electrodes (6) and the interpixel regions (7) being located at two different levels within the detector, **characterized :**
• **in that** the surface (3) of the semiconductor material (2) receiving the detection electrodes (6) is provided with deeply etched region (15) ;
• **in that** said detection electrodes (6) are positioned in said deeply etched region (15) ; and
• **in that** said detection electrodes (6) are located at a level below that of the interpixel regions (7).

2. The photoelectric detection device according to claim 1, **characterized in that** the face (4) opposed to the surface (3) provided with the detection electrodes (6) and oriented toward the incident beam of the radiation to be detected, is coated with a bias electrode (5).

3. The photoelectric detection device as claimed in one of claims 1 and 2, **characterized in that** the semiconductor material is of the II-VI type.

4. The photoelectric detection device as claimed in one of claims 1 to 3, **characterized in that** the detection electrodes (6) are coated with a thickening layer (14) called overlay, which is also conducting, and which thickness is such that the detection electrodes (6) lie at a level below the interpixel regions (7).

5. The photoelectric detection device as claimed in one of claims 1 to 4, **characterized in that** the differences in level between the detection electrodes (6) and the interpixel regions (7) is from a few microns to several tens of microns.

6. The photoelectric detection device as claimed in one of claims 1 to 5, **characterized in that** the interpixel regions (7) are provided with a passivation layer (12).

7. The photoelectric detection device as claimed in one of claims 1 to 5, **characterized in that** the interpixel regions (7) receive an encapsulation layer (13).

8. The photoelectric detection device as claimed in one of claims 1 to 5, **characterized in that** the interpixel regions (7) receive a passivation layer (12) and then receive an encapsulation layer (13).

## Patentansprüche

1. Vorrichtung zur photoelektrischen Detektion, insbesondere für die Detektion von Röntgen- oder Gammastrahlung, enthaltend einen monolithischen Matrix-Detektor (1), der aus einem Halbleitermaterial (2) besteht, von dem eine Seite eine Mehrzahl von Detektionselektroden (6) zur Detektion nach einem Pixelierungs-prinzip umfasst, wobei jede einem Pixel entsprechende Elektrode (6) dazu bestimmt ist, insbesondere mit einer Leseschaltung, elektrisch verbunden zu werden und von den angrenzenden Elektroden durch einen isolierenden Zwischenbereich (7), dem sogenannten Interpixelbereich, getrennt ist, wobei die Detektionselektroden (6) und die Interpixelbereiche (7) auf zwei unterschiedlichen Niveaus in Bezug auf den des Detektor liegen, **dadurch gekennzeichnet, dass**:
- die Fläche (3) des Halbleitermaterials (2), welche die Detektionselektroden (6) aufnimmt, Tiefenätzungen (15) aufweist;
- die Detektionselektroden (6) innerhalb dieser Tiefenätzungen (15) angeordnet sind; und
- die Detektionselektroden (6) auf einem niedrigeren Niveau als die Interpixelbereiche (7) liegen.

2. Vorrichtung zur photoelektrischen Detektion nach Anspruch 1, **dadurch gekennzeichnet, dass** die Seite (4), die der mit den Detektionselektroden (6) versehenen Fläche (3) entgegengesetzt ist und die in Richtung zum einfallenden Strahl der zu erfassenden Strahlung gerichtet ist, mit einer Polarisationselektrode (5) beschichtet ist.

3. Vorrichtung zur photoelektrischen Detektion nach einem der Ansprüche 1 und 2, **dadurch gekennzeichnet, dass** das Halbleitermaterial vom Typ II - VI ist.

4. Vorrichtung zur photoelektrischen Detektion nach einem der Ansprüche 1 bis 3, **dadurch gekennzeichnet, dass** die Detektionselektroden (6) mit einer Verdickungsschicht, der sogenannten Auffüllschicht (14), beschichtet sind, die auch leitfähig ist und deren Dicke derart ist, dass die Detektionselektroden (6) auf einem niedrigeren Niveau als die Interpixelbereiche (7) liegen.

5. Vorrichtung zur photoelektrischen Detektion nach einem der Ansprüche 1 bis 4, **dadurch gekennzeichnet, dass** die Niveauunterschiede zwischen den Detektionselektroden (6) und den Interpixelbereichen (7) einige Mikrometer bis zu mehrere zehn Mikrometer betragen.

6. Vorrichtung zur photoelektrischen Detektion nach einem der Ansprüche 1 bis 5, **dadurch gekennzeichnet, dass** die Interpixelbereiche (7) eine Passivierungsschicht (12) erhalten.

7. Vorrichtung zur photoelektrischen Detektion nach einem der Ansprüche 1 bis 5, **dadurch gekennzeichnet, dass** die Interpixelbereiche (7) eine Einkapselungsschicht (13) erhalten.

8. Vorrichtung zur photoelektrischen Detektion nach einem der Ansprüche 1 bis 5, **dadurch gekennzeichnet, dass** die Interpixelbereiche (7) eine Passivierungsschicht (12) und dann eine Einkapselungsschicht (13) erhalten.
